Europäisches Patentamt

European Patent Office

Office européen des brevets

(19)

(11) Veröffentlichungsnummer: **0 030 335**
**A2**

(12) # EUROPÄISCHE PATENTANMELDUNG

(21) Anmeldenummer: 80107433.7

(22) Anmeldetag: 27.11.80

(51) Int. Cl.³: **H 05 K 13/04, H 05 K 3/34**

(30) Priorität: 06.12.79 DE 2949184

(43) Veröffentlichungstag der Anmeldung: **17.06.81**
**Patentblatt 81/24**

(84) Benannte Vertragsstaaten: **BE FR GB IT NL SE**

(71) Anmelder: **SIEMENS AKTIENGESELLSCHAFT Berlin
und München, Postfach 22 02 61,
D-8000 München 22 (DE)**

(72) Erfinder: **Hadersbeck, Hans, Pistorinistrasse 4,
D-8000 München 90 (DE)**
Erfinder: **Zukier, Hubert, Wilhelm-Busch-Strasse 30,
D-8000 München 71 (DE)**

(54) **Elektrische Leiterplatte.**

(57) Temperaturfeste elektrische Bauteile, insbesondere R-Netzwerke, sind auf der Lötseite einer Leiterplatte angeordnet. Bauteile, die für die Anbringung an der Lötseite einer Leiterplatte vorgesehen sind, weisen an ihrer Trägerplatte an den Anschlußstellen Ausnehmungen für die Ankontaktierung auf. Die Ausnehmungen sind abgeschrägt. Das R-Netzwerk überdeckt den Anschlußfleck auf der Leiterplatte nur zur Hälfte.

EP 0 030 335 A2

SIEMENS AKTIENGESELLSCHAFT          Unser Zeichen
Berlin und München                 VPA
                                       79 P 7 2 2 1

## Elektrische Leiterplatte.

Die Erfindung bezieht sich auf elektrische Leiterplatten, auf denen ein oder mehrere Widerstände und gegebenenfalls noch zusätzlich andere elektrische Bauteile durch auf der Leiterplatte vorgesehene Leiterbahnen zweckdienlich miteinander verbunden sind.

Bisher ist es üblich, daß in elektrotechnischen, insbesondere nachrichtentechnischen Geräten sogenannte Leiterplatten als Verdrahtungsplatten Verwendung finden, auf denen R-, C-, RC- und Hybridnetzwerke auf der Oberseite (Bauteileseite) der Leiterplatte montiert werden. R-Netzwerke werden allgemein durch Aufdampfen oder Aufdrucken von Widerstandsschichten auf relativ dünne Substrate erzeugt. Diese für die Herstellung von R-Netzwerken sehr günstige Methode führt aber zwangsläufig zu einer Form des R-Netzwerkes, die beim Einbau in Verdrahtungsplatten sehr viel Platz erfordert.

Die üblicherweise mit Bauteilebeinchen bestückten R-Netz-

Wed 1 Plr/29.11.1979

werke beanspruchen für die Ankontaktierung auf der Leiterplatte für sich allein sehr viele Anschlußstellen. Zudem
ist auch der Aufwand bei der Herstellung von R-Netzwerken
für eine Bestückung mit Bauteilebeinchen beträchtlich.

Die Kontaktierung der Widerstandsschichten erfolgt in der
Regel durch Anschlußdrähte, die an einem Ende beispielsweise tulpenförmig ausgeformt sind und durch Löten oder
ähnliche Verfahren an die Anschlußbereiche der Widerstandsschicht ankontaktiert werden. Die so hergestellten
Anschlußdrähte werden dann für "dual-in-line" erforderlichenfalls um 90° abgewinkelt und auf der Oberseite der
Leiterplatte in die Lötösen gesteckt. Die Befestigung der
Bauteilebeinchen erfolgt dann beispielsweise durch Tauchlöten.

Der Erfindung liegt die Aufgabe zugrunde, die eingangs definierten elektrischen Leiterplatten so zu konzipieren,
daß wesentlich mehr Bauteile durch günstigere Anordnung
untergebracht werden können und daß ferner an derselben
Anschlußstelle die Ankontaktierung eines zweiten Bauteiles
realisierbar ist. Diese Aufgabe wird nach der Erfindung
dadurch gelöst, daß alle elektrischen Bauteile, die
temperaturstabil bezüglich eines Lötvorganges sind, insbesondere R-Netzwerke, auf der Lötseite einer üblichen
einfachen (nur einseitig kaschierten) Leiterplatte angeordnet sind. Damit steht die gesamte Lötseite der Leiterplatte für die Unterbringung von temperaturstabilen Bauteilen zur Verfügung. Außerdem wird der Platz auf der
Bauteileseite für die üblichen Bauteile durch die R-Netzwerke wesentlich weniger eingeschränkt. Auf diese Weise
kann ein Platz in der Größe der gesamten Fläche einer
Leiterplatte noch zusätzlich zur Bauteileseite ausgenutzt
werden. Besonders hierfür eignen sich R-Netzwerke, die
schon aus funktionellen Gründen so temperaturfest gestaltet sind, daß die Beanspruchung beim Lötvorgang kein
Problem und keine Gefahr bedeutet.

0030335
79 P 7221

Es ist bereits bekannt (Elektronik 1979, Heft 19, S. 52-65) spezielle Bauteile - nämlich in Chipform - auf der Lötseite einer Leiterplatte anzubringen. Diese Anwendung setzt aber eine neue Leiterplatten-Technologie voraus.

Nach einer weiteren Ausgestaltung der Erfindung soll der Aufwand für die Bestückung von Leiterplatten, insbesondere von R-Netzwerken, mit Bauteilebeinchen entfallen. Dies wird nach der Erfindung dadurch erreicht, daß Bauteile Verwendung finden, bei denen an einer temperaturstabilen Trägerplatte an den Anschlußstellen, z. B. der Widerstandsverdrahtung, Ausnehmungen für die Ankontaktierung vorgesehen sind. Diese Ausnehmungen ermöglichen beim Schwallöten eine unmittelbare Benetzung der Anschlußstellen vom R-Netzwerk und den darunter liegenden Anschlußstellen auf der Leiterplatte durch das Lot. Auf diese Weise wird ferner erreicht, daß an den Anschlußstellen der Bauteile, z. B. R-Netzwerke, ohne zusätzlichen Aufwand auch noch Anschlußbeinchen von Bauteilen auf der Bauteileseite der Leiterplatte mit ankontaktiert werden können.

Nach einer Weiterbildung der Erfindung ist die Seitenkante der Ausnehmungen in der Trägerplatte der Bauteile, die parallel zu der Längsseite der Trägerplatte liegen, abgeschrägt ausgeführt und mit einer Metallschicht guter Leitfähigkeit überzogen, die am Rand in die Deckfläche der Trägerplatte hineinreicht. Um beim Aufdampfen der Metallschichten gleichzeitig eine gute Belegung dieser Seitenkanten zu erreichen, können diese Stellen vorzugsweise in einem Winkel von ca. 60° zur Deckfläche ausgeführt sein.

Nach einer weiteren Ausführung der Erfindung sind die Trägerplatten der Bauteile in ihren Abmessungen so festgelegt, daß sie die Anschlußflecken auf der Leiterplatte nur zur Hälfte bedecken. Damit kann das Lot ohne den störenden Einfluß der Lotdepression an die Lötstellen der Leiterplatte gelangen. Außerdem wird damit die Möglichkeit geschaffen, unmittelbar ein zweites Bauteil, z. B. ein weiteres R-Netzwerk, an die gleichen Kontaktstellen der Leiterplatte anzusetzen.

Die Erfindung wird anhand eines Ausführungsbeispiels, dem die besondere Ausbildung von R-Netzwerken zugrundeliegt, die an der Lötseite einer Leiterplatte angeordnet werden können, erläutert.

Figur 1 zeigt in der Vorderansicht den Schnitt durch ein R-Netzwerk und darunter die Draufsicht auf dieses R-Netzwerk in Verbindung mit einer Leiterplatte und

Figur 2 die Kontaktierung von stiftlosen R-Netzwerken auf der Lötseite einer Leiterplatte im Schnitt.

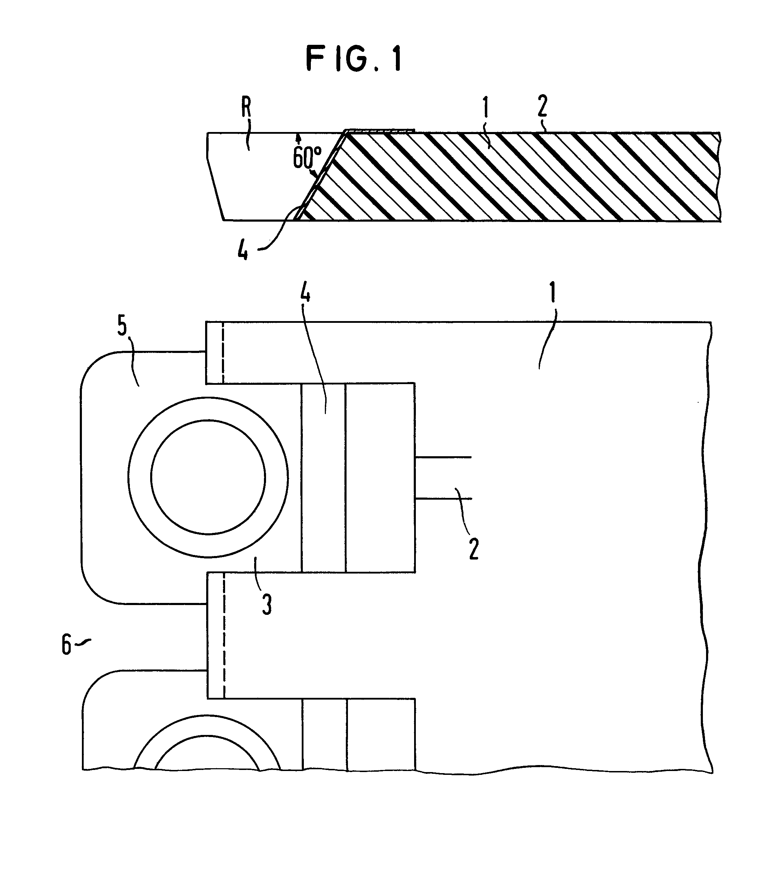

In den Figuren ist eine Trägerplatte 1 eines R-Netzwerkes R dargestellt, das auf der Deckfläche eine Widerstandsschicht 2 trägt. Die Trägerplatte kann z. B. aus einem spritztechnisch verarbeitbaren Kunststoff (z. B. PPS = Polyphenylensulfid) bestehen. Am Rand dieser Trägerplatte sind Ausnehmungen 3 als Anschlußstellen vorgesehen. Um beim Aufdampfen von Metallschichten 4 gleichzeitig eine gute Belegung der Seitenkanten zu erreichen, sollen diese Stellen schräg, und zwar z. B. in einem Winkel von 60° zur Deckfläche, ausgeführt sein. Der Anschlußfleck auf der Leiterplatte ist mit 5 bezeichnet. Diese Anschlußflecken werden von der Trägerplatte nur zur Hälfte bedeckt. Damit kann das Lot ohne den störenden Einfluß der Lotdepression an die Lötstellen der Leiterplatte gelangen. Die Leiterplatte 6, die in der Figur 1

0030335

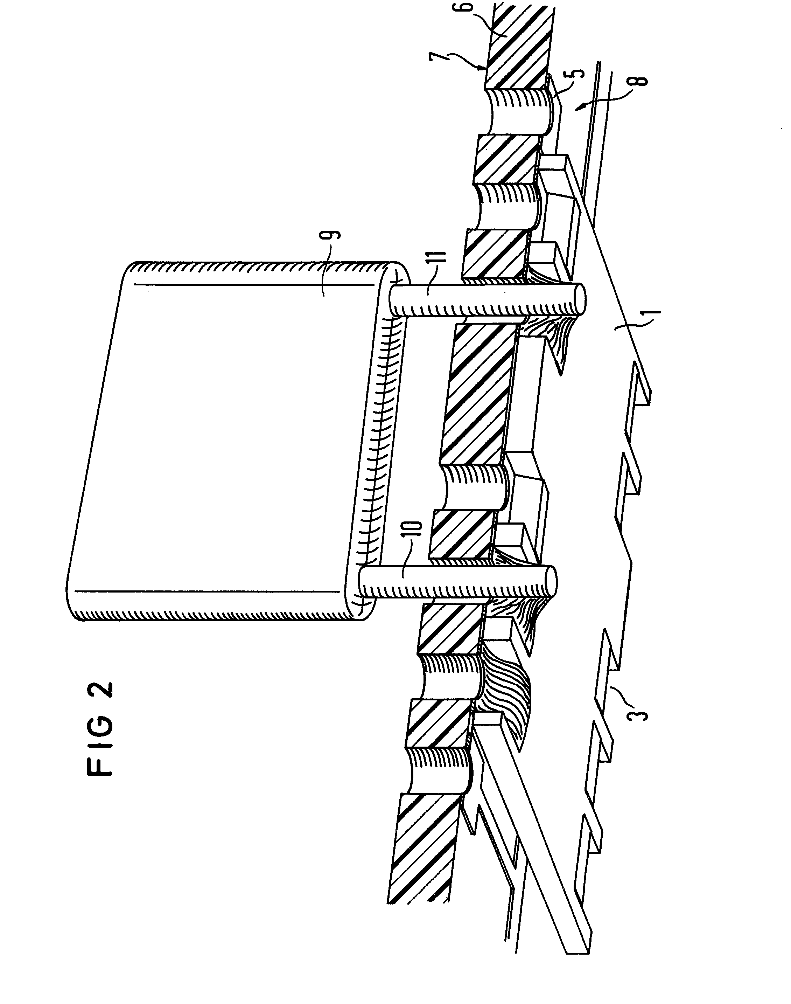

nur in der Draufsicht erscheint und nicht abgegrenzt ist,
wird in der Figur 2 im Schnitt gezeigt. Die Bauteileseite
dieser Leiterplatte ist mit 7 und die Lötseite mit 8
markiert. Außer der Trägerplatte 1 eines RC-Netzwerkes
zeigt die Figur 2 einen Kondensator 9 auf der Bauteileseite 7, der über seine Anschlußdrähte 10 und 11 mit der
im Schnitt dargestellten Leiterplatte 6 mechanisch und
elektrisch verbunden ist.

Die Herstellung eines als Ausführungsbeispiel gewählten
R-Netzwerkes umfaßt folgende Verfahrensschritte:

Spritztechnische Herstellung der als Substrat dienenden
Trägerplatte 1 im Teile- oder Nutzenformat. Anschließend
erfolgt das Aufdampfen der Widerstandsschicht 2 und einer
Metallschicht z. B. aus Kupfer. Daran anschließend wird
mit positiv arbeitendem Fotolack die Metallschicht auf
der Deckfläche beschichtet (z. B. mittels eines Roller-
Coaters aufgetragen). Darauf folgt das Belichten (Galvanikabdeckung zum Aufbau der gut leitenden Anschlußbereiche) und die galvanische Verstärkung der Anschlußbereiche 4. Daran schließt sich ein erneutes Belichten
(Ätzabdeckung für Widerstandsstruktur) an. Nun wird die
aufgedampfte leitfähige Metallschicht durch kurzzeitige
Ätzung entfernt. Darauf folgt das Ätzen der Widerstandsschicht und das Entfernen des verbliebenen Fotolackes.
Schließlich wird die aufgedampfte leitfähige Metallschicht auf der Widerstandsstruktur durch kurzzeitige
Ätzung entfernt. Wenn es erforderlich ist, folgt danach
eine Temperaturbehandlung der Widerstandsschicht. Eine
Korrektur der Widerstandswerte kann beispielsweise durch
Laserbearbeitung erfolgen. Daran anschließend wird eine
Schutzabdeckung der Widerstandsstrukturen, z. B. mit
Schutzlack, hergestellt. Nach dem Trennen der Einzelteile,
die im Nutzenformat hergestellt werden, werden diese auf
der Lötseite einer Leiterplatte behelfsweise befestigt und dann die Leiterplatte, z. B. einem Schwallötverfahren, ausgesetzt.


4 Patentansprüche

2 Figuren

0030335

## Patentansprüche.

1. Elektrische Leiterplatte, auf der ein oder mehrere Widerstände und gegebenenfalls noch zusätzlich andere elektrische Bauteile durch auf der Leiterplatte vorgesehene Leiterbahnen zweckdienlich miteinander verbunden sind, d a d u r c h   g e k e n n z e i c h n e t , daß alle elektrischen Bauteile, die temperaturstabil bezüglich eines Lötvorganges sind, insbesondere R-Netzwerke (R), auf der Lötseite (8) einer üblichen einfachen Leiterplatte (6) angeordnet sind.

2. Leiterplatte nach Anspruch 1, d a d u r c h   g e -k e n n z e i c h n e t ,  daß die Bauteile, insbesondere R-Netzwerke (R), die für die Bestückung auf der Lötseite der Leiterplatte bestimmt sind, an den temperaturstabilen Trägerplatten (1) an den Anschlußstellen Ausnehmungen (3) für die Ankontaktierung aufweisen.

3. Leiterplatte nach Anspruch 2, d a d u r c h   g e -k e n n z e i c h n e t ,  daß die Seitenkante der Ausnehmungen in der Trägerplatte (1) der Bauteile, die parallel zu den Längsseiten der Trägerplatte liegen, abgeschrägt ausgeführt und mit einer Metallschicht (4) guter Leitfähigkeit überzogen sind, die am Rand in die Deckfläche der Trägerplatte (1) hineinreicht.

4. Leiterplatte nach Anspruch 2, d a d u r c h   g e -k e n n z e i c h n e t ,  daß die Trägerplatten (1) der Bauteile in ihren Abmessungen so festgelegt sind, daß sie die Anschlußflecken (Lötaugen 5) auf  der Leiterplatte (6) nur zur Hälfte überdecken.

# FIG. 1

FIG 2

0030335 ....